# EUROPÄISCHE PATENTSCHRIFT

(11) **EP 2 906 737 B1**
(45) Veröffentlichungstag und Bekanntmachung des Hinweises auf die Patenterteilung: **13.12.2017**
(21) Anmeldenummer: 13774191.4
(22) Anmeldetag: 09.10.2013
(51) Int. Cl.: C23C 14/58, C23C 16/56, B24B 9/06, B24B 29/00, B24B 55/02

(54) **VERFAHREN ZUR OBERFLÄCHENBEARBEITUNG VON BESCHICHTUNGEN AUS HARTEM KOHLENSTOFF, DIE AUF SUBSTRATEN AUSGEBILDET SIND**
METHOD FOR THE SURFACE TREATMENT OF COATINGS OF HARD CARBON THAT ARE FORMED ON SUBSTRATES
PROCÉDÉ D'USINAGE SUPERFICIEL DE REVÊTEMENTS EN CARBONE DUR FORMÉS SUR DES SUBSTRATS

(30) Priorität: 10.10.2012 DE 102012020191
(43) Veröffentlichungstag der Anmeldung: 19.08.2015
(73) Patentinhaber: Fraunhofer-Gesellschaft zur Förderung der angewandten Forschung e.V., 80686 München (DE); Bayerische Motoren Werke Aktiengesellschaft, 80809 München (DE)
(72) Erfinder: WEIHNACHT, Volker, 01309 Dresden (DE); MAKOWSKI, Stefan, 01127 Dresden (DE); KRELL, Lisa, 82140 Olching (DE); SCHNAGL, Johann, 82140 Olching (DE)
(74) Vertreter: Pfenning, Meinig & Partner mbB
(86) Internationale Anmeldenummer: PCT/EP2013/071096
(87) Internationale Veröffentlichungsnummer: WO 2014/057005

(56) Entgegenhaltungen:
- EP-A1- 2 062 684
- EP-B1- 1 829 986
- DE-A1- 10 022 677
- DE-A1- 10 027 086
- DE-A1-102010 026 352
- DE-A1-102011 003 254
- DE-A1-102011 087 667
- JP-A- 2008 183 663
- US-A1- 2003 099 835
- US-A1- 2006 027 200
- Axyntec Dünnschichttechnik Gmbh ET AL: "Herstellung Diamantähnlicher Kohlenstoff- schichten (DLC, a-C:H) mittels Plasmaimpax- Verfahren", , 30 September 2005 (2005-09-30), pages 121-127, XP055341404, Retrieved from the Internet: URL:http://www.axyntec.de/downloads/publ_a xyntec_jahrbuch_oberflaechentechnik_2005.p df [retrieved on 2017-02-02]

## Beschreibung

Die Erfindung betrifft ein Verfahren zur Oberflächenbearbeitung von Beschichtungen aus hartem Kohlenstoff, die auf Substraten ausgebildet sind. Es können Beschichtungen verschiedenster Modifikationen von hartem, bzw. diamantähnlichem Kohlenstoff so bearbeitet werden, um eine Oberfläche der Beschichtung mit verbesserten Eigenschaften zur Verfügung zu stellen.

Beschichtungen aus hartem Kohlenstoff können mit unterschiedlichen Technologien auf Substraten ausgebildet werden. Die Kohlenstoffschichten können aus kristallinem Diamant oder amorphem Kohlenstoff bestehen, wobei letztere auch Legierungselemente, wie z.B. Wasserstoff, Stickstoff, Silicium oder auch metallische Elemente enthalten können.

Dabei tritt bei den Beschichtungen mehr oder weniger eine ungleichmäßige Schichtausbildung auf, was zu Fehlstellen, Schichtdickenschwankungen und auch zu einer rauen Oberfläche führt, deren Eigenschaften für viele Anwendungen unzureichend sind. So ist eine Glättung von Oberflächen solcher Beschichtungen häufig gewünscht bzw. auch erforderlich, um entsprechende Bauteile für den jeweiligen Zweck einsetzen zu können.

Insbesondere Beschichtungen, die mit einer als ta-C (tetraedisch gebundener amorpher Kohlenstoff) bezeichneten Modifikation von diamantähnlichem Kohlenstoff gebildet sind, weisen neben einer sehr hohen Härte, die 4.000 HV übertreffen kann. Bedingt durch das zumeist verwendete Lichtbogen-Beschichtungsverfahren tritt meist eine raue Oberflächenstruktur mit erhöhter Rauheit infolge von Wachstumsdefekten und Partikeln auf. Derartige Rauheitsspitzen können bei der Ausbildung solcher Beschichtungen nur durch spezielle technologische Modifikationen (z.B. Partikelfilter) vermieden werden. Diese reduzieren aber wiederum die Beschichtungsrate.

Bei der Abscheidung von Diamantschichten entsteht gewöhnlich eine durch die Kristallfacetten beeinflusste Oberflächenstruktur. Die Abscheidung nanokristalliner glatter Schichten ist mit einer deutlichen Verringerung der Beschichtungsrate verbunden, was die Herstellung unrentabel machen kann.

Für die Bearbeitung der Oberflächen von Diamantbeschichtungen sind neben dem klassischen mechanischen Polieren eine Reihe von Verfahren entwickelt worden, die sich in folgende Gruppen einteilen lassen: thermomechanisches, chemomechanisches, Plasma-, lonenstrahl- sowie Laserpolieren: Diese Verfahren eignen sich auch für die Bearbeitung von harten amorphen Kohlenstoffschichten.

Die thermomechanischen Verfahren basieren auf einer thermisch aktivierten Zersetzungsreaktion des Diamants. So wird bei einer bisher eingesetzten Möglichkeit geschmolzenes Eisen oder eine Eisenlegierung in einer inerten Atmosphäre mit der Beschichtung kontaktiert und dabei Eisenkarbid gebildet, das in die Schmelze eindiffundiert. Neben dem ersichtlich hohen Aufwand können dadurch aber lokale Rauheitsspitzen nicht selektiv beseitigt werden, sondern es kommt zu einem Werkstoffabtrag über die gesamte so beeinflusste Oberfläche. Eine ähnliche Lösung, die jedoch kein geschmolzenes Eisen verwendet, sondern bei Temperaturen knapp unterhalb der Eisenschmelztemperatur arbeitet, ist in US 6, 284,315 beschrieben.

Eine verbreitete Technik ist eine Bearbeitung mit rotierenden Scheiben aus Eisen, Nickel oder Molybdän bei hohen Temperaturen und Drücken in inerter Atmosphäre (siehe. z.B. H. Tokura u.a.; Thin Solid Films 212/1-2 (1992) S. 49-55). Auch hier sind der Aufwand sowie die erforderliche Bearbeitungszeit hoch und es können lediglich ebene, unkonturierte und nicht gekrümmte Oberflächen bearbeitet werden.

Weitere Bearbeitungsverfahren mit Hilfe eines Plasmas, lonenstrahls bzw. Lasers arbeiten Kontaktlos und sind auch für nicht-planare Oberflächen geeignet. Sie sind jedoch sehr aufwändig und bedingen Vakuumbedingungen bzw. kontrollierte Atmosphären.

Aus EP 1 829 986 B1 ist es bekannt, eine Bearbeitung mechanisch unter Einsatz eines rotierenden Elementes, an dem borstenförmige oder plattenförmige Elemente aus einem Metall vorhanden sind, durchzuführen. Bei Rotation des rotierenden Elementes bewegen sich die stirnseitigen Enden der borstenförmigen oder plattenförmigen Elemente über die Oberfläche. Dabei befinden sie sich in punktförmigen oder linienförmigen Kontakt mit der Oberfläche und es kann so eine Glättung des entsprechend bearbeiteten Bereichs erreicht werden. Es hat sich dabei aber gezeigt, dass die erforderliche Produktivität noch nicht ausreichend erreicht werden konnte und die erreichbare Oberflächengüte noch verbesserungswürdig ist. So können durch Partikel oder so genannte Droplets ausgebildete Erhebungen einer solchen Beschichtung nicht vollständig eingeebnet werden und die Oberflächenrauheit weist noch entsprechende Defizite auf. Diese führen zu einem unerwünschten Verschleiß bei einer Gleitbeanspruchung.

JP 2008-183 663 A beschreibt Verfahren zum Polieren von Wasserstoff enthaltenden amorphen Kohlenstoffschichten, bei dem ein Schmieröl und ein Zusatzstoff eingesetzt wird

Es ist daher Aufgabe der Erfindung effektivere Möglichkeiten für die Bearbeitung von Oberflächen an Beschichtungen aus hartem Kohlenstoff, die zu einer verbesserten Glättung und insbesondere zu einer Vermeidung von Rauheitsspitzen führen, vorzuschlagen, die den Aufwand und die Kosten reduzieren.

Erfindungsgemäß wird diese Aufgabe mit einem Verfahren, das die Merkmale des Anspruchs 1 aufweist, gelöst. Vorteilhafte Ausgestaltungen und Weiterbildungen können mit in den untergeordneten Ansprüchen bezeichneten Merkmalen erreicht werden.

Bei dem erfindungsgemäßen Verfahren wird eine mechanische Oberflächenbearbeitung durchgeführt, bei der zusätzlich eine bei der Oberflächenbearbeitung flüssige organische Kohlenstoffverbindung, in der keine zusätzlichen abrasiv wirkenden Partikel enthalten sind, im Einflussbereich des/der mechanischen Kontakte(s) bei der mechanischen Bearbeitung und der Oberfläche der Beschichtung aus hartem Kohlenstoff vorhanden ist oder in diesen Einflussbereich zugeführt wird. Durch diese Maßnahme wird der lokale Abtrag an den Rauheitsspitzen der zu bearbeitenden Oberfläche durch eine zusätzliche chemische Wirkung der zugeführten Flüssigkeit beschleunigt.

Eine mechanische Oberflächenbearbeitung kann durch Schleifen, Polieren, Läppen, einen Strahlprozess, einen Trowalierprozess oder durch Einsatz eines rotierenden Elementes, an dem borstenförmige oder plattenförmige Elemente aus einem Metall vorhanden sind, durchgeführt werden.

Bei einem Trowalierprozess können beschichtete Bauteile in einen Behälter gegeben werden, in dem eine flüssige Kohlenstoffverbindung und Schleifkörper enthalten sind. Durch eine Bewegung und/oder Ultraschalleinwirkung kann die gewünschte Oberflächenbearbeitung erreicht werden.

Beim Schleifen, Polieren oder auch Läppen kann die flüssige Kohlenwasserstoffverbindung dem Einflussbereich der jeweiligen Werkzeuge an der zu bearbeitenden Oberfläche der Beschichtung zugeführt werden.

Beim Einsatz der erwähnten rotierenden Elemente kann so vorgegangen werden, wie dies in EP 1 829 986 B1 beschrieben ist. Es wird auf deren Offenbarungsgehalt vollumfänglich Bezug genommen.

Bei dem erfindungsgemäßen Verfahren kann eine flüssige organische Kohlenstoffverbindung eingesetzt werden, die vorzugsweise ausgewählt ist Aus reinen, auf fettsäurehaltigen chemischen Verbindungen, Alkanen und Alkenen.

Bevorzugt kann es sich dabei um Alkene, insbesondere Polyalphaolefin, sauerstoff- und hydroxyhaltige Kohlenstoffverbindungen, wie Fettsäuren in freier Form, deren Ester, Mono-, Di- oder Triglyceride, Ölsäure, Glycerolmonooleat oder Pflanzenöle handeln.

Vorteilhaft kann die Oberflächenbearbeitung bei einer Temperatur von mindestens 50 °C durchgeführt werden. Dadurch kann die erforderliche Zeit reduziert werden. Es kann bei einer Temperatur bis zu 300 °C, bevorzugt bis zu 200 °C gearbeitet werden. Dabei sollte jedoch die flüssige Phase während der Oberflächenbearbeitung der eingesetzten Kohlenstoffverbindung eingehalten bleiben.

Die erfindungsgemäße Oberflächenbearbeitung wird an einer Beschichtung aus ta-C oder kristallinem Diamant durchgeführt.

Es kann auch ein Gemisch in dem mindestens eine flüssige organische Kohlenstoffverbindung enthalten ist, die ausgewählt ist aus Fettsäuren in freier Form, deren Ester, Mono-, Di- oder Triglyceride, insbesondere Polyalphaolefin, Ölsäure, Glycerolmonooleat und Pflanzenölen, eingesetzt werden. Dabei kann es sich um eine Lösung oder Emulsion handeln, die mit der jeweiligen Kohlenstoffverbindung gebildet ist.

Die eingesetzte flüssige Kohlenstoffverbindung bildet einen Hilfsstoff bei der Oberflächenbearbeitung, mit dem der Beschichtungswerkstoff beschleunigt abgetragen und aus dem Einflussbereich entfernt werden kann. Die erforderliche Bearbeitungszeit kann verkürzt und es kann eine verbesserte Oberflächengüte der Beschichtung erreicht werden. Gegenüber dem Stand der Technik können die Kosten reduziert werden.

Bei sehr harten Beschichtungen kann eine Oberflächenbearbeitung erst mit der Erfindung ermöglicht werden.

Es kann ein Herausreißen von Beschichtungswerkstoff, wie er beim Stand der Technik auftrat, vermieden werden, so dass eine geschlossene gleichmäßig dicke Beschichtung nach der erfindungsgemäßen Oberflächenbearbeitung erhalten werden kann, die frei von Fehlstellen oder Löchern ist.

Es können auf Gleitverschleiß beanspruchte Bauteile und Komponenten erfindungsgemäß bearbeitet werden. Bei Automobilanwendungen können dies Komponenten des Ventiltriebs, des gesamten Motors, des Antriebsstrangs, der Verdichter oder Pumpen oder anderen Hilfsaggregaten, beispielsweise Kolbenbolzen, Nockenwellen, Schlepphebel, Tassenstößel, Ventile, Kolbenringe, Zahnräder, Pumpenkolben und -stößel oder Einspritzdüsennadeln sein.

Es ist auch eine Bearbeitung anderer Maschinekomponenten und Bauteile, wie Führungsschienen, Werkzeugen, die in verschiedensten industriellen Anwendungen eingesetzt werden, möglich.

Nachfolgend soll die Erfindung beispielhaft näher erläutert werden.

Eine 2 µm dicke ta-C Schicht auf einem Kolbenbolzen für die Anwendung in Verbrennungsmotoren wird mit dem erfindungsgemäßen Verfahren geglättet. Die Ausgangsrauheit der ta-C Schichtoberfläche beträgt ungefähr Rz = 1,5 µm. Zur Glättung der Oberfläche werden mehrere Kolbenbolzen hintereinander auf einer langsam rotierenden Drehachse befestigt. Die Bearbeitung der rotierenden Kolbenbolzen erfolgt nun durch seitliches Andrücken eines Siliziumkarbid-Schleifbandes mit Körnung P800. Unmittelbar vor der Kontaktzone mit dem Kolbenbolzen wird auf das Schleifband permanent ein dünner Film von Polyalphaolefin aufgesprüht, so dass Polyalphaolefin im Einflussbereich des mechanischen Kontaktes bei der Oberflächenbearbeitung auf der Oberfläche der Beschichtung aus hartem Kohlenstoff vorhanden ist.

Durch die Verwendung des Hilfsstoffes Polyalphaolefin verkürzt sich die Bearbeitungszeit bis zum Erreichen einer hinreichend glatten ta-C Oberfläche mit Rz<0,5 µm etwa um den Faktor 10, verglichen mit einer Bearbeitung ohne diesen Hilfsstoff.

## Patentansprüche

1. Verfahren zur Oberflächenbearbeitung von Beschichtungen aus amorphen Kohlenstoff, die auf Substraten ausgebildet sind, bei dem eine mechanische Oberflächenbearbeitung durchgeführt wird, bei der zusätzlich eine bei der Oberflächenbearbeitung flüssige organische Kohlenstoffverbindung, in der keine zusätzlichen abrasiv wirkenden Partikel enthalten sind, im Einflussbereich des/der mechanischen Kontakte(s) bei der Oberflächenbearbeitung und der Oberfläche der Beschichtung vorhanden ist oder in den Einflussbereich zugeführt wird, **dadurch gekennzeichnet, dass** die Beschichtungen aus ta-C (tetraedisch gebundenem amorphen Kohlenstoff) oder kristallinem Diamant besteht.

2. Verfahren nach Anspruch 1, **dadurch gekennzeichnet, dass** eine mechanische Oberflächenbearbeitung durch Schleifen, Polieren, Läppen, einen Strahlprozess, einen Trowalierprozess oder durch Einsatz eines rotierenden Elementes, an dem borstenförmige oder plattenförmige Elemente aus einem Metall vorhanden sind, durchgeführt wird.

3. Verfahren nach Anspruch 1 oder 2, **dadurch gekennzeichnet, dass** eine flüssige organische Kohlenstoffverbindung eingesetzt wird, die ausgewählt ist aus reinen Fettssäuren, fettsäurehaltigen chemischen Verbindungen, Alkanen und Alkenen.

4. Verfahren nach Anspruch 3, **dadurch gekennzeichnet, dass** als Kohlenwasserstoffverbindung, ein Alken, insbesondere Polyalphaolefin, sauerstoff- und hydroxyhaltige Kohlenstoffverbindungen, wie Fettsäuren in freier Form, deren Ester, Mono-, Di- oder Triglyceride, Ölsäure, Glycerolmonooleat oder Pflanzenöle eingesetzt werden.

5. Verfahren nach einem der vorhergehenden Ansprüche, **dadurch gekennzeichnet, dass** die Oberflächenbearbeitung bei einer Temperatur von mindestens 50 °C durchgeführt wird.

6. Verfahren nach einem der vorhergehenden Ansprüche, **dadurch gekennzeichnet, dass** ein Gemisch in dem mindestens eine flüssige organische Kohlenstoffverbindung enthalten ist, die ausgewählt ist aus fettsäurehaltigen chemischen Verbindungen oder Alkenen, eingesetzt wird.

## Claims

1. A method for the surface treatment of coatings of amorphous carbon which are formed on substrates, in which a mechanical surface treatment is carried out in which an organic carbon compound which is liquid during the surface treatment and in which no additional abrasively acting particles are contained is additionally present in the region of influence of the mechanical contact(s) during the surface treatment and in the surface of the coating or is supplied into the region of influence,
**characterized in that**
the coatings comprise ta-C (tetrahedrally bonded amorphous carbon) or crystalline diamond.

2. A method in accordance with claim 1, **characterized in that**
a mechanical surface treatment is carried out by grinding, polishing, lapping, by a blasting process, by a vibratory grinding process or by use of a rotating element at which bristle-like or plate-like elements of a metal are present.

3. A method in accordance with claim 1 or claim 2, **characterized in that**
a liquid organic carbon compound is used that is selected from pure fatty acids, chemical compounds containing fatty acids, alkanes and alkenes.

4. A method in accordance with claim 3, **characterized in that** an alkene, in particular polyalphaolefin, carbon compounds containing oxygen and hydroxyl such as fatty acids in a free form, their esters, monoglycerides, diglycerides or triglycerides, oleic acid, glycerol monooleate or plant oils are used as a hydrocarbon compound.

5. A method in accordance with one of the preceding claims, **characterized in that** the surface treatment is carried out at a temperature of at least 50°C.

6. A method in accordance with one of the preceding claims, **characterized in that** a mixture is used in which at least one liquid organic carbon compound is contained that is selected from chemical compounds containing fatty acids or from alkenes.

## Revendications

1. Procédé de traitement de surface de revêtements constitués de carbone amorphe, qui sont réalisés sur des substrats, dans lequel un traitement de surface mécanique est effectué, au cours duquel en outre un composé de carbone organique liquide lors du traitement de surface, dans lequel n'est contenue aucune particule abrasive supplémentaire, est présent dans la zone d'influence du ou des contacts mécaniques lors du traitement de surface et de la surface du revêtement, ou est introduit dans la zone d'influence, **caractérisé en ce que** les revêtements sont constitués de C-ta (carbone amorphe relié de manière tétraédrique) ou d'un diamant cristallin.

2. Procédé selon la revendication 1, **caractérisé en ce qu'**un traitement de surface mécanique est effectué par ponçage, polissage, rodage, un processus par jet, un processus de vibro-abrasion ou par l'utilisation d'un élément rotatif, sur lequel sont disposés des éléments en forme de brosses ou de plaques métalliques.

3. Procédé selon la revendication 1 ou 2, **caractérisé en ce qu'**un composé carboné organique liquide est utilisé, qui est sélectionné parmi des acides gras purs, des composés chimiques contenant des acides gras, des alcanes et des alcènes.

4. Procédé selon la revendication 3, **caractérisé en ce que** le composé hydrocarboné utilisé est un alcène, plus particulièrement une poly-alpha-oléfine, des composés carbonés contenant de l'oxygène et des hydroxydes, comme des acides gras sous forme libre, leurs esters, mono-, di- ou triglycérides, des acides oléiques, du mono-oléate de glycérol ou des huiles végétales.

5. Procédé selon l'une des revendications précédentes, **caractérisé en ce que** le traitement de surface est effectué à une température d'au moins 50 °C.

6. Procédé selon l'une des revendications précédentes, **caractérisé en ce qu'**un mélange est utilisé, dans lequel est contenu au moins un composé carboné organique liquide, qui est sélectionné parmi des composés chimiques contenant des acides gras ou des alcènes.
